# EUROPÄISCHE PATENTANMELDUNG

(11) **EP 4 346 095 A1**
(43) Veröffentlichungstag der Anmeldung: **03.04.2024**
(21) Anmeldenummer: 23200289.9
(22) Anmeldetag: 28.09.2023
(51) Int. Cl.: H02S 40/22, F21V 5/00, F21V 5/02, F21V 5/04, F21V 7/00, G02B 19/00, G02B 5/04

(54) **ANORDNUNG MIT BIFAZIALEM SOLARMODUL UND LICHTUMLENKVORRICHTUNG**

(30) Priorität: 30.09.2022 DE 102022125375
(71) Anmelder: Müller, Helmut Frank Ottomar, 40625 Düsseldorf (DE)
(72) Erfinder: Müller, Helmut Frank Ottomar, 40625 Düsseldorf (DE)
(74) Vertreter: Cohausz & Florack

(57) **Zusammenfassung**

Die Erfindung betrifft unter anderem eine Anordnung umfassend ein bifaziales Solarmodul mit einer Vorderseite und einer Rückseite und eine mikrostrukturierte Lichtumlenkvorrichtung mit einer Mikrostruktur, wobei die Anordnung derart ausgebildet ist, dass die mikrostrukturierte Lichtumlenkvorrichtung einfallendes Sonnenlicht mittels Brechung und/oder Reflexion zumindest teilweise und unmittelbar auf die Rückseite des bifazialen Solarmoduls umlenkt.

## Beschreibung

Die vorliegende Erfindung betrifft eine Anordnung umfassend ein bifaziales Solarmodul.

Bifaziale Photovoltaik(PV)-Zellen, -Module und -Systeme übernehmen verstärkt Marktanteile der monofazialen PV-Technologien. Aufgrund neuer Zellenaufbauten, welche die Kontakte der opaken Rückseite durch getrennte, filigrane Kontakte ersetzen, kann Solarstrahlung auch von der Rückseite des Moduls die Zelle erreichen. Geringfügige Anpassungen der Fertigungsschritte haben zu bifazialen Zellen geführt, die rückseitige Wirkungsgrade von > 60% bis über 95% erzielen. Bifaziale Zellen werden heute in zahlreichen Varianten angeboten (z.B. PERC+, n-PERT, HIT, etc.) und viele Fertigungslinien wurden inzwischen auf bifaziale Zellen umgestellt, vgl. [1].

Durch die beidseitige Bestrahlung der Solarzelle von der Vorder- und Rückseite können derzeit Steigerungen des Wirkungsgrades von 5% bis 25% erreicht werden, abhängig vom Neigungswinkel der Zelle und dem Rückstrahlvermögen des Untergrundes. Aufgrund der etwas komplexeren Herstellung sind bifaziale Solarmodule etwas teurer als übliche monofaziale Module. Die Preise gleichen sich aber zunehmend an, auch weil die meisten Hersteller auf den effektiveren Modultyp setzen und immer weniger monofaziale Module hergestellt werden. Die geringfügigen Mehrkosten der bifazialen Zellen können bei geeigneter Aufstellung der PV-Anlage bzgl. Neigungswinkel und Rückstrahlvermögen des Untergrundes durch die Steigerung des Wirkungsgrades schnell amortisiert werden. Wirtschaftlich ist die optische Sonnenlichtumlenkung, wenn die spezifischen Kosten des Gesamtsystems pro kWh Ertrag unter denen monofazialer Module liegen, vgl. [2].

Insofern ist es wünschenswert, die Menge an auf die Rückseite eines bifazialen Solarmoduls einfallenden Sonnenlichts möglichst weiter zu steigern.

Zwar wäre es denkbar, den Untergrund strahlungstechnisch zu optimieren (etwa mit spiegelnden Flächen). Allerdings wird dadurch lediglich die Ausbeute der Menge an Licht, die den Untergrund erreicht, gesteigert, die jedoch aufgrund der durch das Solarmodul selbst verursachten Verschattung begrenzt ist. Durch eine Änderung der Ausrichtung oder Anordnung des PV-Moduls selbst könnte zwar mehr Licht auf den Untergrund gelangen, dies führt aber in der Regel zu einer verringerten Effizienz auf der Vorderseite des Solarmoduls und/oder zu einem erhöhten Platzbedarf.

Alternativ wäre denkbar, mittels Beugung bzw. holographischer Methoden eine gewisse Lichtumlenkung zu erzielen. Nachteilig hieran ist allerdings, dass bei derartigen Methoden Licht nur sehr schmal-bandig in einem sehr begrenzten Wellenlängenbereich und für nur sehr begrenzte Winkelbereiche beeinflusst werden kann.

Vor diesem Hintergrund stellt sich vorliegend die Aufgabe, eine Anordnung mit einem bifazialen Solarmodul anzugeben, mit der die Effizienz der bifazialen Solarmodule effektiv, das heißt insbesondere kosteneffektiv und mit möglichst geringem konstruktivem Aufwand, gesteigert wird.

Gemäß einem ersten Aspekt der Erfindung wird eine Anordnung offenbart, umfassend (zumindest) ein bifaziales Solarmodul mit einer Vorderseite und einer Rückseite und (zumindest) eine mikrostrukturierte Lichtumlenkvorrichtung mit einer Mikrostruktur. Dabei ist die Anordnung vorzugsweise derart ausgebildet, dass die mikrostrukturierte Lichtumlenkvorrichtung einfallendes Sonnenlicht mittels Brechung und/oder Reflexion zumindest teilweise und insbesondere unmittelbar auf die Rückseite des bifazialen Solarmoduls umlenkt.

Es versteht sich, dass die Anordnung auch mehrere Solarmodule und mehrere Lichtumlenkvorrichtungen umfassen kann.

Unter einem bifaziales Solarmodul (auch Photovoltaikmodul, PV-Modul oder Solarpanel genannt) wird ein Solarmodul verstanden, bei dem Solarzellen zum Einsatz kommen, die sowohl auf der Vorder-, als auch auf der Rückseite photoelektrisch aktiv sind (bifaziale Solarzellen).

Unter einer mikrostrukturierten Lichtumlenkvorrichtung wird eine Vorrichtung (insbesondere ein im Wesentlichen flächiges Panel) verstanden, welche zumindest teilweise mit einer Mikrostruktur versehen ist. Dabei kann die Lichtumlenkvorrichtung beispielsweise eine einseitig oder beidseitig aufgebrachte Mikrostruktur aufweisen, welche auf Teilen oder der gesamten Lichtumlenkvorrichtung vorgesehen ist. Beispielsweise weist die Mikrostruktur sich regelmäßig wiederholende Mikrostrukturelemente auf. Die Größenordnung derartiger Mikrostrukturelemente liegt im Mikrometerbereich, beispielsweise im Bereich von 10µm bis 1000µm, vorzugsweise von 50µm bis 500µm. Beispiele für vorteilhafte Mikrostrukturen bzw. mikrostrukturierte Lichtumlenkvorrichtungen werden im Folgenden noch näher erläutert.

Beispielsweise ist die Lichtumlenkvorrichtung eine (insbesondere für die hier interessierenden Wellenlängen) transparente Lichtumlenkvorrichtung. Die Lichtumlenkung erfolgt beispielsweise bei der Transmission des Sonnenlichts durch die Lichtumlenkvorrichtung, das heißt insbesondere bei der Transmission des Sonnenlichts von einer Lichteintrittsseite zu einer dieser gegenüberliegenden Lichtaustrittsseite der Lichtumlenkvorrichtung. Die Brechung und/oder Reflexion erfolgt dabei insbesondere an oder in den Strukturelementen der Mikrostruktur bei der Transmission des Sonnenlichts durch die Lichtumlenkvorrichtung.

Durch die vorgesehene mikrostrukturierte Lichtumlenkvorrichtung kann einfallendes Sonnenlicht mittels Brechung und/oder Reflexion zumindest teilweise unmittelbar auf die Rückseite des bifazialen Solarmoduls umgelenkt werden. Dadurch, dass die Lichtumlenkvorrichtung auf dem Prinzip der Brechung und/oder Reflexion basiert, kann insbesondere im Vergleich zu Methoden, die auf optischer Beugung oder optischen Gittern basieren (wie beispielsweise holographischen Methoden), eine breitbandige Lichtumlenkung, welche einen breiten Wellenlängenbereich des Sonnenlichts (etwa weite Teile des sichtbaren Lichts und der Infrarotstrahlung) umlenkt, erzielt werden. Ebenfalls kann dadurch, eine Umlenkung von Licht, welches über einen weiten Winkelbereich auf die Lichtumlenkvorrichtung einfällt, umgelenkt werden, was ebenfalls bei auf Beugung basierenden Methoden praktisch nicht möglich ist.

Unter einfallendem Sonnenlicht wird das beim bestimmungsgemäßen Gebrauch bzw. bei der bestimmungsgemäßen (in der Regel fixen) Orientierung der Anordnung auf die Anordnung fallende Sonnenlicht verstanden. Da sich der Sonneneinfallswinkel auf die hierin beschriebene Anordnung im Laufe des Tages stark ändern kann, sind die hierin beschriebenen Eigenschaften dabei zumindest zeitweise realisierbar.

Damit die mikrostrukturierte Lichtumlenkvorrichtung einfallendes Sonnenlicht mittels Brechung und/oder Reflexion zumindest teilweise unmittelbar auf die Rückseite des bifazialen Solarmoduls umlenkt, sind das Solarmodul (insbesondere seine Größe), die Lichtumlenkvorrichtung (insbesondere ihre Größe und die durch die Mikrostruktur hervorgerufenen Lichtumlenkeigenschaften) und ihre Größen und Anordnungen (insbesondere ihre Neigung) relativ zueinander entsprechend aneinander angepasst.

Darunter, dass die Lichtumlenkvorrichtung das Sonnenlicht unmittelbar auf die Rückseite des bifazialen Solarmoduls umlenkt, wird insbesondere verstanden, dass das Sonnenlicht außerhalb oder nach der Lichtumlenkvorrichtung ohne eine weitere Umlenkung (etwa durch Brechung oder Reflexion an einem separaten Spiegel) auf die Rückseite des bifazialen Solarmoduls treffen kann. Hierdurch werden eine kompakte Anordnung und ein hohe Effizienz erreicht, da Verluste durch weitere optische Elemente vermieden werden. In einem Beispiel ist die Lichtumlenkvorrichtung ausschließlich zur Lichtumlenkung ausgebildet. Alternative, kann die Lichtumlenkvorrichtung aber auch zusätzlich dazu eingerichtet sein, im Anschluss an die Lichtumlenkung zudem eine Streuung des umgelenkten Lichts zu erzeugen. Die Lichtumlenkvorrichtung kann somit beispielsweise nicht nur eine Mikrostruktur zur Lichtumlenkung sondern zudem weiterhin ein Struktur zur Lichtumlenkung (beispielsweise eine weitere (Streu-)Schicht, die beispielsweise ebenfalls mit einer für diesen Zweck vorgesehenen Mikrostruktur versehen ist) umfassen. So kann beispielsweise die für die Lichtumlenkung vorgesehene Mikrostruktur auf der Lichtaustrittsseite entsprechend modifiziert sein. Alternativ kann die Lichtumlenkvorrichtung auch hinter der für die Lichtumlenkung lichtaustrittsseitig vorgesehenen Mikrostruktur zusätzlich noch eine weitere Schicht oder Scheibe mit einer dedizierten Mikrostruktur für die Lichtstreuung umfassen. Damit kann insbesondere eine gleichmäßigere Bestrahlung des Solarmoduls erzielt werden. Unabhängig davon kann die Lichtumlenkvorrichtung aber vorteilhaft kompakt als im Wesentlich flächiges oder plattenförmiges Element oder Scheibe ausgebildet werden.

Darunter, dass die Lichtumlenkvorrichtung das Sonnenlicht zumindest teilweise auf die Rückseite des bifazialen Solarmoduls umlenkt, wird insbesondere verstanden, dass zum einen lediglich ein Teil des Spektrums des Sonnenlichts umgelenkt zu werden braucht und zum anderen nicht der gesamte Teil des Sonnenlichts, welcher umgelenkt wird, zwingend auf die Rückseite des Solarmoduls treffen muss. Allerdings sei an dieser Stelle noch einmal hervorgehoben, dass die beschriebenen Ausgestaltungen grundsätzlich dazu geeignet sind, einen Großteil des für ein Solarmodul relevanten Anteils des Sonnenlichtspektrum (insbesondere das sichtbare Licht und die Infrarotstrahlung) umzulenken, und aufgrund der erzielten Umlenkwinkel für einen großen Bereich der möglichen Einfallswinkel die Rückseite des Solarmoduls vorteilhaft auszuleuchten.

Unter Sonnenlicht wird hier und im Folgenden insbesondere das für das Solarmodul relevante oder verwertbare Sonnenlicht verstanden. Mit Sonnenlicht ist daher insbesondere ganz oder teilweise das sichtbare Licht und/oder ganz oder teilweise die solare Infrarotstrahlung gemeint. Die hier und im Folgenden beschriebenen Eigenschaften beziehen sich also insbesondere auf Sonnenlicht in diesem Bereich.

Dabei kann angenommen werden, dass die hier beschriebenen Eigenschaften (wie beispielswiese Winkelabhängigkeit und Umlenkvermögen) aufgrund der zu vernachlässigenden Wellenlängenabhängigkeit dieser Eigenschaften bei den beschriebenen Strukturen im Mikrometerbereich für den Bereich des sichtbaren Lichts und der solaren Infrarotstrahlung gelten und erzielbar sind.

Gemäß einer beispielhaften Ausgestaltung ist die Anordnung derart ausgebildet, dass die Vorderseite des bifazialen Solarmoduls unmittelbar von einfallendem Sonnenlicht beschienen wird. Die Vorderseite des bifazialen Solarmoduls kann also beispielsweise wie ein gewöhnliches (monofaziales) Solarmodul ausgerichtet werden. Die beschriebene Lichtumlenkvorrichtung kann beispielsweise winkelig an einer Kante des Solarmoduls angebracht werden, ohne das Solarmodul vorderseitig zu verschatten und dabei Sonnenlicht, welches normalerweise nicht auf die Vorderseite des Solarmoduls trifft, direkt oder unmittelbar auf die Rückseite des Solarmoduls umlenken. Durch Anordnung kann also zumindest zweitweise einfallendes Sonnenlicht zeitgleich auf die Vorderseite und die Rückseite des Solarmoduls treffen.

Alternativ ist jedoch auch denkbar, dass auch die Vorderseite des bifazialen Solarmoduls nicht unmittelbar von einfallendem Sonnenlicht beschienen wird, sondern, zumindest zeitweise, auch durch Licht, welches durch eine Lichtumlenkvorrichtung hindurchtritt oder durch diese umgelenkt wurde, beleuchtet wird. So kann das Solarmodul beispielsweise im Wesentlichen senkrecht angeordnet werden und entsprechende Lichtumlenkvorrichtungen können sich beispielsweise winkelig von der Oberkante des Solarmoduls beidseitig weg erstrecken. In diesem Fall kann zu bestimmten Zeiten die Vorderseite und zu bestimmten Zeiten die Rückseite des Solarmoduls durch umgelenktes Sonnenlicht beleuchtet werden.

Gemäß einer beispielhaften Ausgestaltung der Anordnung ist die Mikrostruktur der mikrostrukturierten Lichtumlenkvorrichtung derart ausgebildet, dass Sonnenlicht zumindest unter einem Einfallswinkel zur Senkrechten der Lichtumlenkvorrichtung von 40° bis 50°, vorzugsweise von 35° bis 55°, weiter vorzugsweise von 30° bis 60°, besonders bevorzugt von 15° bis 70° unmittelbar auf die Rückseite des bifazialen Solarmoduls umgelenkt wird. Beispielsweise wird die größte Umlenkung für Einfallswinkel im Bereich von etwa 45° erzielt. Bei entsprechend kleinen und großen Einfallswinkeln (die typischerweise geringeren Umlenkwinkeln unterliegen) kann es erforderlich sein, dass die Dimensionierung von Solarmodul und Lichtumlenkvorrichtung (etwa entsprechend lange Solarmodule im Vergleich zur Lichtumlenkvorrichtung) entsprechend aneinander angepasst sind. Der Anteil des auf die Rückseite des bifazialen Solarmoduls umgelenkten Sonnenlichts hängt dabei im Wesentlichen von den Dimensionen und der Anordnung von Lichtumlenkvorrichtung und Solarmodul und zudem von der Stärke der realisierbaren Lichtumlenkung (die im Allgemeinen wiederum vom Einfallswinkel des Sonnenlichts abhängt) ab. Sind diese Parameter entsprechend aufeinander abgestimmt, ist eine unmittelbare Beleuchtung der Rückseite des Solarmoduls über entsprechend große Bereiche von Einfallswinkeln erreichbar.

In einem Beispiel sind die Lichtumlenkvorrichtung und das Solarmodul im Querschnitt gesehen im Wesentlichen gleich lang. Beispielsweise haben Lichtumlenkvorrichtung und Solarmodul die gleiche Fläche. In einem anderen Beispiel ist das Solarmodul im Querschnitt gesehen länger als die Lichtumlenkvorrichtung. Beispielsweise hat das Solarmodul eine größere Fläche als die Lichtumlenkvorrichtung, was insbesondere sinnvoll ist, wenn lediglich flache Umlenkwinkel durch die Lichtumlenkvorrichtung realisiert werden.

Gemäß einer beispielhaften Ausgestaltung ist die Mikrostruktur der mikrostrukturierten Lichtumlenkvorrichtung derart ausgebildet, dass die relative Transmission im Bereich von Einfallswinkel von Sonnenlicht zur Senkrechten der Lichtumlenkvorrichtung von 40° bis 50°, vorzugsweise von 35° bis 55°, weiter vorzugsweise von 30° bis 60°, besonders bevorzugt von 15° bis 70°, zumindest 40%, vorzugsweise zumindest 50%, besonders bevorzugt zumindest 60% beträgt. Die beschriebene Lichtumlenkung kann insbesondere durch die im Folgenden noch näher beschriebenen Mikrostrukturen erreicht werden. In diesem Bereich kann auch eine relative Transmission von 60% bis 80% erreicht werden. Unter der relativen Transmission wird hierbei eine Transmission und damit Umlenkung in die gewünschte Richtung verstanden. Ein Teil des Sonnenlichts wird zwar ebenfalls transmittiert und umgelenkt, aber vom Solarmodul weggelenkt werden. Hiervon zu unterscheiden ist die allgemeine Transmission der Lichtumlenkvorrichtung im Vergleich zur Absorption und Reflexion. Diese kann beispielsweise für eine strukturierte Glas oder PMMA-Scheibe 90% betragen, was sodann beispielsweise dazu führt, dass (ausgehend von den oben angegebenen 60% bis 80%) effektiv 54% bis 72% der einfallenden Sonnenstrahlung auf die Rückseite der bifazialen Solarzelle umgelenkt werden.

Gemäß einer beispielhaften Ausgestaltung der Anordnung ist die Mikrostruktur der mikrostrukturierten Lichtumlenkvorrichtung derart ausgebildet ist, dass für Einfallswinkel von Sonnenlicht zur Senkrechten der Lichtumlenkvorrichtung im Bereich von 45° der Umlenkwinkel zur Senkrechten der Lichtumlenkvorrichtung zumindest 40°, vorzugsweise zumindest 50, besonders bevorzugt zumindest 60° beträgt. Die angegebenen Winkel sind in Bezug auf die Senkrechte der Lichtumlenkvorrichtung angegebene. Insgesamt wird das Licht um die Summe dieser Winkel umgelenkt. Mit den hierin beschriebenen Mikrostrukturen sind Umlenkwinkel von bis zu 62° bei einem Einfallswinkel von etwa 45° realisierbar. Bei geringeren oder größeren Einfallswinkeln sind die Umlenkwinkel typischerweise geringer. So kann beispielsweise bei einem Einfallswinkel von 20° ein Umlenkwinkel von etwa 10° realisiert sein.

Gemäß einer beispielhaften Ausgestaltung der Anordnung ist die Mikrostruktur der mikrostrukturierten Lichtumlenkvorrichtung derart ausgebildet ist, dass für Einfallswinkel von Sonnenlicht zur Senkrechten der Lichtumlenkvorrichtung von 40° bis 50°, vorzugsweise von 35° bis 55°, weiter vorzugsweise von 30° bis 60°, besonders bevorzugt von 15° bis 70°, ein Großteil (also insbesondere mehr als 50%) des umgelenkten Sonnenlichts in einen Winkelbereich von 10° bis 65°, besonders bevorzugt von 20° bis 40°, besonders bevorzugt 25° bis 35° umgelenkt wird. Hierdurch kann eine hohe Effizienz und vorteilhafte Ausleuchtung der Rückseite des Solarpanels erreicht werden. Auf Mikrostrukturen mit entsprechenden Eigenschaften wird weiter unten noch genauer eingegangen.

Gemäß einer beispielhaften Ausgestaltung der Anordnung ist die Mikrostruktur der mikrostrukturierten Lichtumlenkvorrichtung derart ausgebildet, dass das einfallende Sonnenlicht winkelselektiv umgelenkt wird. So kann das einfallende Sonnenlicht beispielsweise unter bestimmten Einfallswinkeln (beispielsweise einem ersten Einfallswinkelbereich) die Lichtumlenkvorrichtung im Wesentlichen unabgelenkt transmittieren, während das einfallende Sonnenlicht beispielsweise unter anderen Einfallswinkeln (beispielsweise einem zweiten Einfallswinkelbereich) durch die Lichtumlenkvorrichtung abgelenkt wird. So kann Licht beispielsweise im Wesentlichen nur aus einer Raumhälfte umgelenkt werden, während Licht aus der andern Raumhälfte im Wesentlichen unabgelenkt oder jedenfalls unter geringerer Ablenkung durch die Lichtumlenkvorrichtung hindurchtreten kann.

Gemäß einer beispielhaften Ausgestaltung der Anordnung sind die mikrostrukturierte Lichtumlenkvorrichtung und das bifaziale Solarmodul winkelig zueinander, insbesondere unter einem Winkel von zumindest 60°, vorzugsweise zumindest 75°, vorzugsweise im Wesentlichen rechtwinkelig, angeordnet. Bei derartigen Winkeln kann ein kompakter Aufbau bei effizienter Lichtumlenkung auf die Rückseite des Solarmoduls erzielt werden. Das Solarmodul kann dabei sowohl im Wesentlichen horizontal, vertikal oder schräg angeordnet sein. Unter im Wesentlichen horizontal angeordneten Solarmodulen soll insbesondere zu verstehen sein, dass diese auch noch eine Neigung von etwa 2° bis 5° aufweisen können, um beispielsweise Schmutzablagerungen und chemische Beeinträchtigung auszuschließen.

Gemäß einer beispielhaften Ausgestaltung der Anordnung ist die mikrostrukturierte Lichtumlenkvorrichtung derart ausgebildet, dass diese einfallendes Sonnenlicht breitbandig, insbesondere zumindest teilweise im Bereich des sichtbaren Lichts und/oder zumindest teilweise im Bereich der solaren Infrarotstrahlung, insbesondere im Bereich der nahe, mittleren und/oder fernen Infrarotstrahlung, umlenkt. Unter sichtbarem Licht wird insbesondere der Wellenlängenbereich von etwa 400 bis 700 nm verstanden. Unter Infrarotstrahlung wird insbesondere der Wellenlängenbereich von etwa 700 nm bis 1 mm verstanden.

Gemäß einer beispielhaften Ausgestaltung der Anordnung verläuft im bestimmungsgemäß Gebrauch der Anordnung das Solarmodul im Querschnitt gesehen im Wesentlichen horizontal oder vertikal und/oder die Lichtumlenkvorrichtung im Querschnitt gesehen im Wesentlichen vertikal oder horizontal. Alternativ können aber auch schräg verlaufende Solarmodule und/oder schräg verlaufende Lichtumlenkvorrichtungen vorgesehen sein.

Gemäß einer beispielhaften Ausgestaltung umfasst die Anordnung weiterhin einen Montagegrund, wobei der Montagegrund eine Freifläche, ein Dach, insbesondere ein Flachdach, ein geneigtes Dach oder ein Glasdach, eine Fassade oder eine Glasscheibe, insbesondere eine Isolierglasscheibe, ist, und wobei das Solarmodul und/oder die mikrostrukturierte Lichtumlenkvorrichtung auf dem Montagegrund befestigt oder in diesen integriert ist. Grundsätzlich sind aber auch Bauwerke wie Schallschutzwände, Dämme oder Böschungen als Montagegründe möglich. So kann beispielsweise im Falle der Integration in eine Fassade das (im Wesentlichen horizontal oder leicht geneigt vom der Fassade abstehende) Solarmodul zudem eine Sonnenschutzfunktion übernehmen. Im Fall der Montage auf einer Freifläche oder einem Dach kann sich die Lichtumlenkvorrichtung beispielsweise im Wesentlichen über den Bereich zwischen einer Kante des Solarmoduls und dem Montagegrund erstrecken. Im Falle der Integration in ein Isolierglas, kann das Solarmodul beispielsweise entlang der Außenseite angeordnet sein bzw. einen Teil der Außenseite darstellen, während die Lichtumlenkvorrichtung(en) sich jeweils in einem Zwischenraum des Isolierglases erstrecken (etwa senkrecht oder schräg zur Außenseite mit den Solarmodulen).

Gemäß einer beispielhaften Ausgestaltung der Anordnung ist die strukturierte Lichtumlenkvorrichtung im Wesentlichen flächig ausgebildet und/oder besteht aus Glas oder PMMA.

Gemäß einem zweiten Aspekt der Erfindung wird zudem eine Verwendung einer mikrostrukturierte Lichtumlenkvorrichtung mit einer Mikrostruktur zur Umlenkung von einfallendem Sonnenlicht mittels Brechung und/oder Reflexion zumindest teilweise unmittelbar auf eine Rückseite eines bifazialen Solarmoduls offenbart. Hinsichtlich beispielhafter vorteilhafter Ausgestaltungen der Verwendung der mikrostrukturierten Lichtumlenkvorrichtung zur Umlenkung wird auf die obigen Ausführungen verwiesen.

Im Folgenden werden Beispiele mikrostrukturierter Lichtumlenkvorrichtungen bzw. der Mikrostrukturen mit weiteren beispielhaften Ausgestaltungen beschrieben.

So kann die (für die hier interessierenden Wellenlängen) transparente Lichtumlenkvorrichtung beispielsweise auf der dem Lichteinfall zugewandten Seite eine zylinderlinsenförmige Oberflächenstruktur aufweisen. Hierunter ist zu verstehen, dass die Mikrostruktur einzelne Mikrostrukturelemente aufweist, welche jeweils entsprechend zylinderlinsenförmig ausgebildet sind. Das Linsenprofil kann dabei einen 90°-Ausschnitt aus einer plankonvexen Struktur darstellen. Auf der dem Lichtaustritt zugewandten Seite (also der der Lichteintrittsseite abgewandten Seite) kann die Lichtumlenkvorrichtung eine stabprismenförmige Oberflächenstruktur besitzen. Hierunter ist zu verstehen, dass die Mikrostruktur einzelne Mikrostrukturelemente aufweist, welche jeweils stabprismenförmig ausgebildet sind Der Krümmungsradius des Linsenprofils kann mit den Schenkellängen des 90°-Ausschnitts identisch sein oder größer als dieser sein.

Die Lichtumlenkvorrichtung kann beispielsweise aus einer einzige Platte oder Folie oder aber aus zwei getrennt gefertigten Platten oder Folien bestehen, welche die linsenförmigen und/oder prismenförmigen Oberflächenstrukturen aufweist/aufweisen. Im Falle von getrennten Platten oder Folien können diese wiederum beidseitig auf einen entsprechenden Träger aufgebracht sein, sodass die Oberflächenstrukturen die Außenseiten eines Dreier-Verbundes bilden.

Im Übrigen kann auf die Offenlegungsschrift DE 10 2008 055 857 A1 verwiesen werden, der weitere technische Details und Ausgestaltungen hinsichtlich der Mikrostruktur zu entnehmen sind (vgl. hierzu insbesondere Abs. [0011] bis [0017]), welche hierin durch Bezugnahme aufgenommen sein sollen.

Eine Verbesserung der soeben beschriebenen Mikrostruktur kann dadurch erreicht werden, dass die zylinderlinsenförmigen Strukturelemente im Querschnitt gesehen jeweils einen Abschnitt mit einem konvexen Linsenprofil aufweisen, wobei die zylinderlinsenförmigen Strukturelemente jeweils eine sich an den Abschnitt mit dem konvexen Linsenprofil anschließende Erhöhung aufweisen.

Dabei kann die Erhöhung eine sich an den Abschnitt mit dem konvexen Linsenprofil anschließende steigende Flanke und eine sich an die steigende Flanke anschließende fallende Flanke umfassen. Die sich an den Abschnitt mit dem konvexen Linsenprofil anschließende steigende Flanke der Erhöhung kann ohne oder mit (konkaver) Krümmung ausgebildet sein. Der Krümmungsradius der steigenden Flanke kann geringer sein als der Krümmungsradius des konvexen Linsenprofils. Die steigende Flanke und die fallende Flanke der Erhöhung können einen Winkel von mindestens 20° und/oder höchstens 50°, bevorzugt von mindestens 25° und/oder höchstens 40° einschließen. Die fallende Flanke der Erhöhung kann mit der Normalen der Lichteintrittsseite einen Winkel von mehr als 0°, bevorzugt von mindestens 0,1° und/oder von höchstens 5°, weiter bevorzugt von höchstens 3° einschließen. Weiterhin kann der Übergang zwischen der steigenden Flanke und der fallenden Flanke abgerundet sein. Die Breite des Abschnitts mit dem konvexen Linsenprofil kann im Wesentlichen gleichgroß oder größer sein als die Breite der Erhöhung.

Der Abstand zwischen der Oberflächenstruktur mit zylinderlinsenförmigen Strukturelementen und der Oberflächenstruktur mit stabprismenförmigen Strukturelementen kann größer sein als die Brennweite des konvexen Linsenprofils.

Im Übrigen kann auf die Offenlegungsschrift DE 10 2019 105 092 A1 verwiesen werden, der weitere technische Details und Ausgestaltungen hinsichtlich der Mikrostruktur zu entnehmen sind (vgl. hierzu insbesondere Abs. [0010] bis [0030]), welche hierin durch Bezugnahme aufgenommen sein sollen.

In einer beispielhaften Ausgestaltung weist die Lichtumlenkvorrichtung zumindest zwei Scheiben auf. Die Scheiben können beispielsweise im Wesentlichen parallel verlaufen und einen Zwischenraum aufweisen. Beispielsweise weist die Lichtumlenkvorrichtung die Mikrostruktur auf den beiden einander zugewandten Innenseiten auf. Beispielsweise ist eine erste Mikrostruktur auf der Innenseite der lichteintrittsseitigen Scheibe vorgesehen und einer zweite (andere) Mikrostruktur auf der lichtaustrittsseitigen Scheibe vorgesehen. Beispielsweise sind die jeweiligen Außenseiten (also die dem Lichteinfall zugewandte Seite (Lichteintrittsseite) und die gegenüberliegende, dem Lichtaustritt zugewandte Seite (Lichtaustrittsseite)) nicht strukturiert. Die Scheiben können beispielsweise mit einem Zwischenraum nach Art einer Isolierverglasung mit dichtem Randverbund zusammengebaut werden, wobei die Lichtumlenkung dann durch die Strukturierung der beiden Innenflächen zum Zwischenraum erfolgt.

Beispielsweise weist die erste Mikrostruktur auf der Innenseite der lichteintrittsseitigen Scheibe im Schnitt gesehen im Wesentlichen dreiecksförmige Strukturelemente oder Erhebungen auf. Beispielsweise weist die zweite Mikrostruktur auf der Innenseite der lichtaustrittsseitigen Scheibe im Schnitt gesehen abgerundete Strukturelemente oder Vorsprünge auf, welche im Bereich der Spitze beispielsweise einseitig abgerundete sein können, im Schnitt gesehen beispielsweise im Wesentlichen mit einer Geometrie eines Viertelkreises. Es hat sich gezeigt, dass hierdurch eine Umlenkung von einfallender Sonnenstrahlung aus einem vergleichsweise großen Winkelbereich (etwa 15° bis 65°) in einen gewünschten Winkelbereich (etwa 27° bis 73°) erfolgen kann.

Dieser Aufbau hat den Vorteil, dass eine Funktionsbeeinträchtigung durch Verschmutzung, durch häufiges Reinigen oder durch physikalische Beschädigung der strukturierten Oberfläche weitestgehend vermieden werden kann, wobei durch den zweischichtigen Aufbau der Lichtumlenkvorrichtung (im Vergleich zu einem dreischichtigen Aufbau mit einer mittigen mikrostrukturierten Lichtumlenkvorrichtung, welche beidseitig eine zusätzliche Schutzscheibe oder-folie aufweist) reduzierte Transmissionsverluste erreicht werden können.

Die zuvor in dieser Beschreibung beschriebenen beispielhaften Ausgestaltungen der vorliegenden Erfindung sollen auch in allen Kombinationen miteinander offenbart verstanden werden. Insbesondere sollen beispielhafte Ausgestaltungen in Bezug auf die unterschiedlichen Aspekte als offenbart verstanden werden.

Weitere vorteilhafte beispielhafte Ausgestaltungen der Erfindung sind der folgenden detaillierten Beschreibung einiger beispielhafter Ausführungsformen der vorliegenden Erfindung, insbesondere in Verbindung mit den Figuren, zu entnehmen. Die Figuren sollen jedoch nur dem Zwecke der Verdeutlichung, nicht aber zur Bestimmung des Schutzbereiches der Erfindung dienen. Insbesondere sollen Merkmale, die in den Figuren enthalten sind, keineswegs als notwendiger Bestandteil der vorliegenden Erfindung erachtet werden.

In der Zeichnung zeigt
- Fig. 1a), b): Ausführungsbeispiele von Anordnungen mit einem bifazialen Solarmodul und eine Lichtumlenkvorrichtung;
- Fig. 2: der Verlauf einer simulierten relativen Transmission einer Lichtumlenkvorrichtung;
- Fig. 3a), b): simulierte Lichtverteilkurven von Licht, welches durch eine Lichtumlenkvorrichtung umgelenkt wird, abhängig vom Einfallswinkel;
- Fig. 4: Veranschaulichung unterschiedlicher Sonnen-Einfallswinkel auf die Lichtumlenkvorrichtung und resultierende zugehörige Umlenkwinkel;
- Fig. 5a)-g): verschiedene Ausführungsbeispiele von Anordnungen;
- Fig. 6a)-d): verschiedene Ausführungsbeispiele von in Isolierglas integrierten Anordnungen;
- Fig. 7a), b): ein Beispiel einer Mikrostruktur einer Lichtumlenkvorrichtung;
- Fig. 8: ein weiteres Beispiel einer optimierten Mikrostruktur einer Lichtumlenkvorrichtung; Und
- Fig. 9: ein weiteres Beispiel einer Mikrostruktur einer Lichtumlenkvorrichtung.

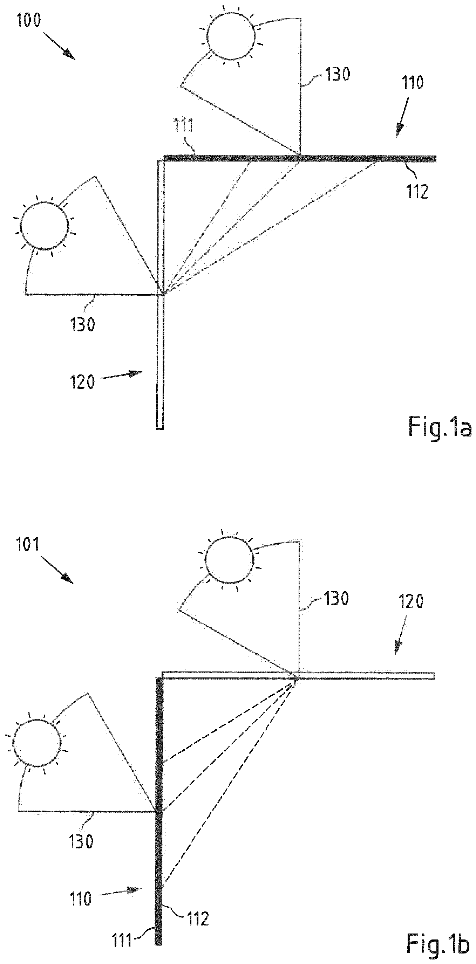

Die Fig. 1a), b) zeigen Ausführungsbeispiele von Anordnungen mit einem bifazialen Solarmodul und eine Lichtumlenkvorrichtung. Gezeigt sind zwei Anordnungen 100, 101 im bestimmungsgemäßen Gebrauch jeweils mit einem bifazialen Solarmodul 110 mit einer Vorderseite 111 und einer Rückseite 112 und mit einer mikrostrukturierten Lichtumlenkvorrichtung 120 mit einer Mikrostruktur (nicht dargestellt). Die Anordnungen 100, 101 sind jeweils derart ausgebildet, dass die mikrostrukturierte Lichtumlenkvorrichtung 120 einfallendes Sonnenlicht 130 mittels Brechung und/oder Reflexion zumindest teilweise und unmittelbar auf die Rückseite 112 des bifazialen Solarmoduls 110 umlenkt. Die Vorderseite 111 des bifazialen Solarmoduls 110 wir jeweils direkt durch Sonnenlicht 130 beaufschlagt. Im Fall der Anordnung 100 ist das Solarmodul 110 im Querschnitt gesehen horizontal, die Lichtumlenkvorrichtung 120 vertikal angeordnet. Im Fall der Anordnung 101 ist das Solarmodul 110 im Querschnitt gesehen vertikal, die Lichtumlenkvorrichtung 120 horizontal angeordnet. Im Querschnitt gesehen haben das Solarmodul 110 und die Lichtumlenkvorrichtung 120 in etwa die gleiche Länge (Seitenverhältnis von 1:1). Dabei kann die unmittelbare Umlenkung auf die Rückseite des bifazialen Solarmoduls jedoch beinhalten, dass als Teil der Lichtumlenkvorrichtung eine Lichtstreuung in oder hinter der Mikrostruktur vorgesehen ist, um zu einer gleichmäßigen Bestrahlung der Modulfläche zu führen.

Fig. 1 zeigt somit zunächst die prinzipiellen Anordnungsmöglichkeiten des Solarmoduls und der optischen Lichtumlenkvorrichtung gezeigt, die beispielsweise in Abhängigkeit von geographischer Breite und Orientierung gewählt werden. Weiterhin ist die Art der Modulaufstellung zu berücksichtigen, wie z.B. im freien Gelände oder gebäudeintegriert (Dächer, Wände), wie im Folgenden noch genauer erläutert.

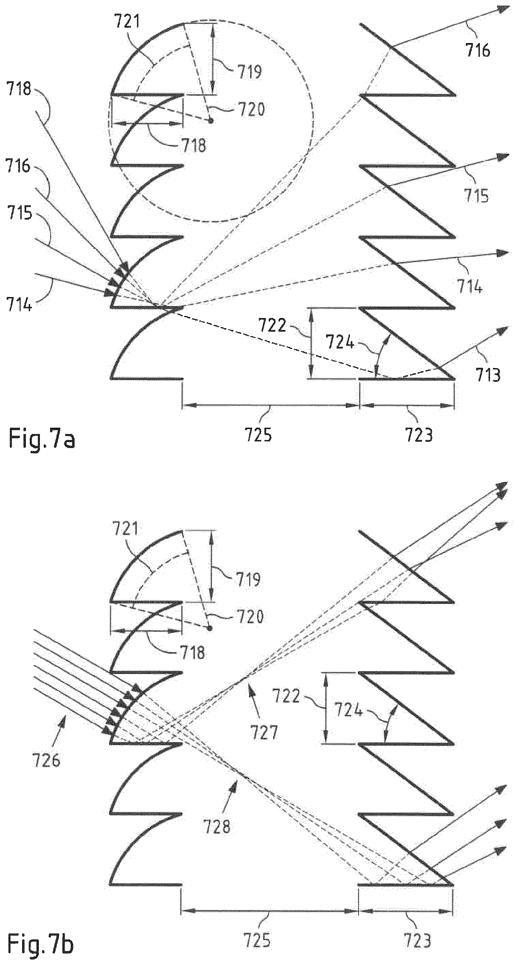

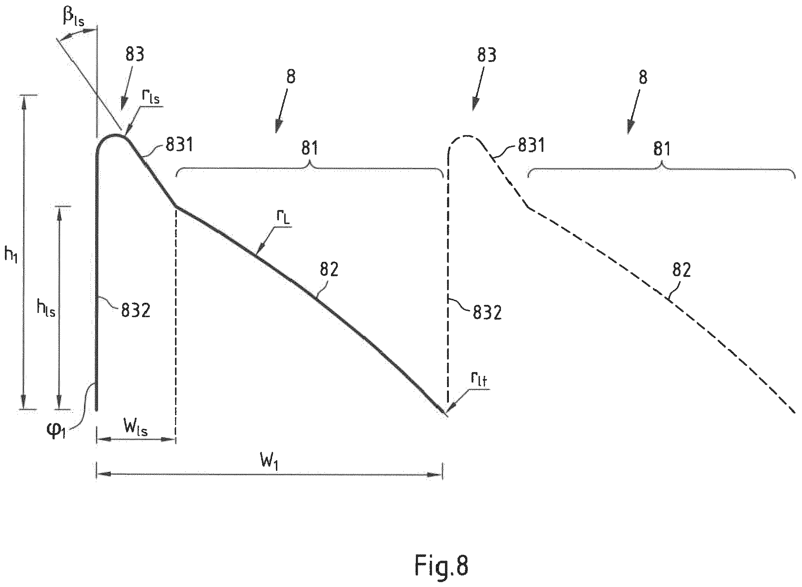

Auf diese Weise kann eine Umlenkung von direktem Sonnenlicht auf die Rückseite von Solar- oder PV-Modulen durch ein starres optisches System erfolgen, das keine Sonnennachführung erfordert. Besonders geeignet sind beispielsweise die im Zusammenhang mit den Fig. 7 und 8 noch genauer beschriebenen Mikrostrukturen aufgrund der vergleichsweise geringen Fertigungskosten.

Grundsätzlich ist es aber auch denkbar, die dargestellten Anordnungen als (zum Beispiel einachsig) nachgeführtes Systeme auszubilden, insbesondere bei Nachführung um eine horizontale Achse.

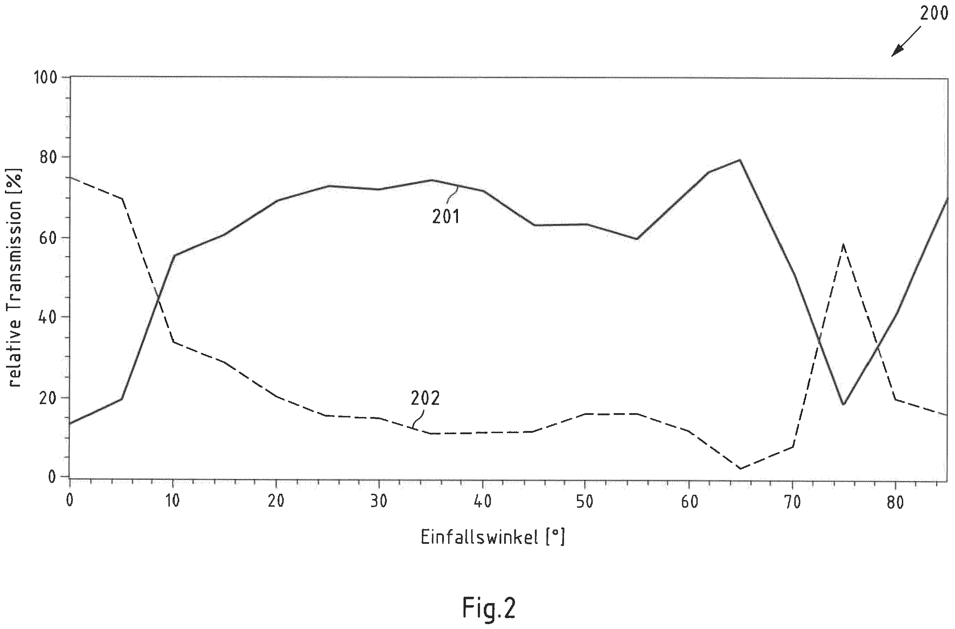

Fig. 2 veranschaulicht in einem Diagramm 200 den Verlauf einer simulierten relativen Transmission (y-Achse) einer Lichtumlenkvorrichtung in Abhängigkeit von Einfallswinkel (x-Achse). Die mikrostrukturierte Lichtumlenkvorrichtung ist dabei diejenige, die noch genauer in Zusammen mit Fig. 7 beschrieben wird. Es ist dabei der relative Anteil der Transmission, der in die gewünschte Richtung des Solarmoduls umgelenkt wird (Linie 201), und relative Anteil der Transmission, der unerwünscht weg vom Solarmodul umgelenkt wird (Linie 202). Die erwünschte Umlenkung kann im Wesentlichen für Sonneneinfallswinkel von etwa 15° bis 70° erreicht werden. In diesem Bereich beträgt die relative Transmission des umgelenkten Lichts in die gewünschte Richtung (Linie 201) überwiegend bei 60% bis 80% . Setzt man für die Transmission (im Vergleich zu Reflexion und Absorption) einer strukturierten Glas- oder PMMA-Scheibe 90% an, so können effektiv entsprechend 54% bis 72% der einfallenden Sonnenstrahlung in die gewünschte Richtung auf bifaziale Solarzellen umgelenkt werden.

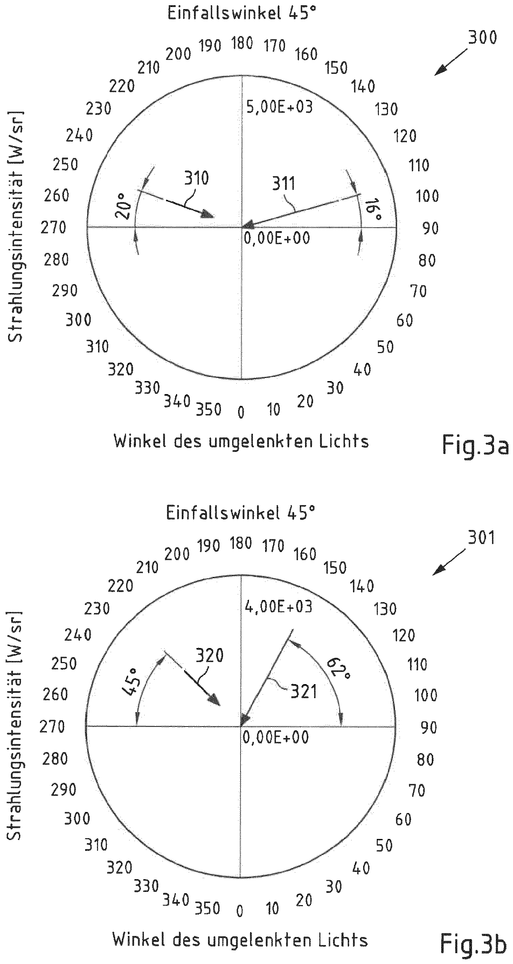

Dabei ist zu berücksichtigen, dass der Umlenkwinkel in Abhängigkeit vom vertikalen Sonneneinfallswinkel variiert, wie die in Fig. 3a), b) dargestellten Messergebnisse zeigen. So zeigen Fig. 3a), b) simulierte Lichtverteilkurven 300, 301 von Licht, welches durch eine Lichtumlenkvorrichtung umgelenkt wird, wobei jeweils das Maximum der Strahlungsintensität des Umgelenkten Lichts für einen bestimmten Einfallswinkel gezeigt ist. So beträgt der Einfallswinkel einmal 20° (einfallsseitiger, kurzer Pfeil 310 in Fig. 3a) und einmal 45° (einfallsseitiger, kurzer Pfeil 320 in Fig. 3b) zur Senkrechten der Lichtumlenkvorrichtung. Die Umlenkwinkel variieren zwischen den Extremen von 10° und 62° (jeweiliges Maximum der Strahlungsintensität des umgelenkten Lichts) ausgangsseitig zur Senkrechten der Lichtumlenkvorrichtung gemessen (lange Pfeile 311, 321 in Fig. 3a, b). Es hat sich gezeigt, dass sich der Großteil des umgelenkten Lichts in dem Bereich von 25° bis 35° bewegt, vgl. hierzu auch [3].

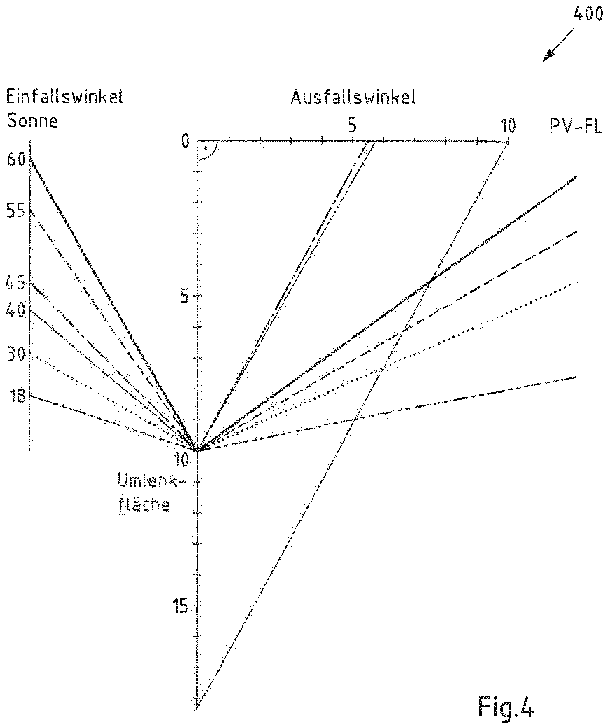

Fig. 4 veranschaulicht in einem Diagramm 400 eine beispielhafte Abhängigkeit unterschiedlicher Sonnen-Einfallswinkel von 18°, 30°, 40°, 45°, 55°, 60° auf eine Lichtumlenkvorrichtung (nicht dargestellt auf y-Achse) und die resultierenden zugehörigen ausgangsseitigen Umlenkwinkel (Solarmodul auf x-Achse, nicht dargestellt). Es ist zu erkennen, dass die größte Umlenkung für Einfallswinkel von 40° und 45° erfolgt. Sonnenlicht mit größeren (55°, 60°) und kleineren (18°, 30°) Einfallswinkeln wird weniger stark umgelenkt.

Erkennbar zeigt Fig. 4 am Beispiel eines Solarmoduls mit Lichtumlenkvorrichtung, dass die Größe der Umlenkfläche der Lichtumlenkvorrichtung Einfluss auf die Bestrahlung der PV-Fläche hat: Bei Umlenkwinkeln >45° (in Fig. 4 die beispielhaft eingezeichneten umgelenkten Lichtstrahlen resultierend aus einfallendem Licht mit den Einfallswinkeln von 18°, 30°, 55°, 60°) müsste in diesem Beispiel die Umlenkfläche größer sein als die Fläche des Solarmoduls, um das Solarmodul vollständig zu bestrahlen. Entsprechend kann bei einer Ausgestaltung die Fläche (und insbesondere die Länge im Querschnitt, wie in Fig. 4 zu sehen) der Lichtumlenkvorrichtung größer sein als diejenige des Solarmoduls. Bei Umlenkwinkeln < 45° (in Fig. 4 die beispielhaft eingezeichneten umgelenkten Lichtstrahlen resultierend aus einfallendem Licht mit den Einfallswinkeln von 40°, 45°) müsste die Solarmodulfläche größer sein als die Umlenkfläche, um die gesamt umgelenkte Bestrahlung aufzufangen. Entsprechend kann bei einer Ausgestaltung die Fläche (und insbesondere die Länge im Querschnitt, wie in Fig. 4 zu sehen) des Solarmoduls größer sein als diejenige der Lichtumlenkvorrichtung. Werden etwa gleichgroße Umlenk- und Solarmodulflächen gewählt, treten bei Umlenkwinkeln >45° allerdings ungleichmäßige Strahlungsintensitäten auf dem Solarmodul auf. Effizienzverluste durch ungleichmäßige Strahlungsverteilung auf dem Solarmodul können beispielsweise durch Bypass-Dioden für einzelne Solarzellen oder Zellen-Strings vermieden werden. Bei Umlenkwinkeln < 45° ginge bei nicht ausreichend großen Solarmodulen ein Teil der umgelenkten Strahlung an dem Solarmodul vorbei, sofern es nicht vergrößert wird. Alternativ kann ein Reflektor am Ende des Solarmoduls angeordnet werden. Das Größenverhältnis von Umlenkfläche zu Modulfläche, welches in Fig. 4 mit etwa 1:1 angenommen wurde, kann in Abhängigkeit von Orientierung, Anordnungsprinzip (vgl. Fig. 1) und Anwendungsfall optimiert werden. Wie oben angesprochen kann auch eine Lichtstreuung in oder hinter der lichtumlenkenden Mikrostruktur zu einer gleichmäßigeren Bestrahlung der Modulfläche führen.

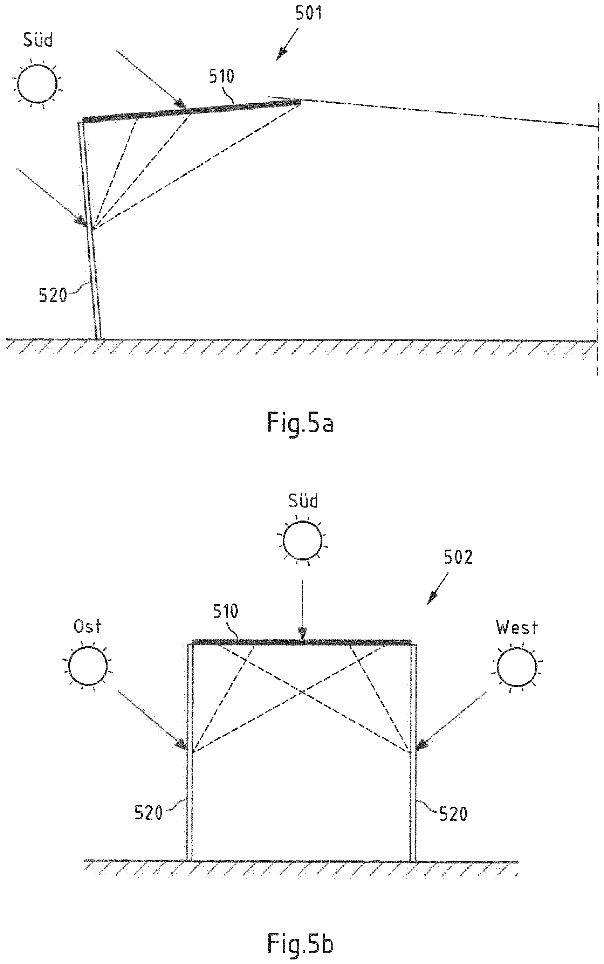

In den Fig. 5a)-g) sind nun beispielhaft verschiedene Ausführungsformen von Anordnungen 501 - 507 mit Solarmodul 510 und Lichtumlenkvorrichtung 520 gezeigt. Grundsätzlich ist die Anwendung von bifazialen PV-Modulen mit Lichtumlenkung sowohl auf freien Flächen als auch gebäudeintegriert in Dächern und/oder Fassaden möglich.

So zeigt Fig. 5a) eine Anordnung 501 mit Solarmodul 510 und Lichtumlenkvorrichtung 520 auf einer Freifläche oder auf einem Flachdach, mit Südorientierung. Die Anordnung 501 entspricht im Wesentlichen der in Fig. 1a) gezeigten. Für die durch Solarmodule 510 gebildete PV-Flächen ist statt der horizontalen eine wie in Fig. 5a gezeigte, geneigte Anordnung 501 vorteilhaft oder sogar erforderlich, um den Ablauf von Regenwasser sicher zu stellen.

Die Anordnung 502 in Fig. 5b) ist ebenfalls auf einer Freifläche oder auf einem Flachdach in Ost-/West-Orientierung vorgesehen. Im Unterschied zu der Anordnung 501 aus Fig. 5a sind hier im Querschnitt gesehen beidseitig des im Wesentlich horizontal verlaufenden Solarmoduls 510 Lichtumlenkvorrichtungen 520 vorgesehen. Die Anordnung 502 in Fig. 5b) ermöglicht praktisch eine Verdoppelung der Bestrahlung auf der Rückseite der Solarmodule 510.

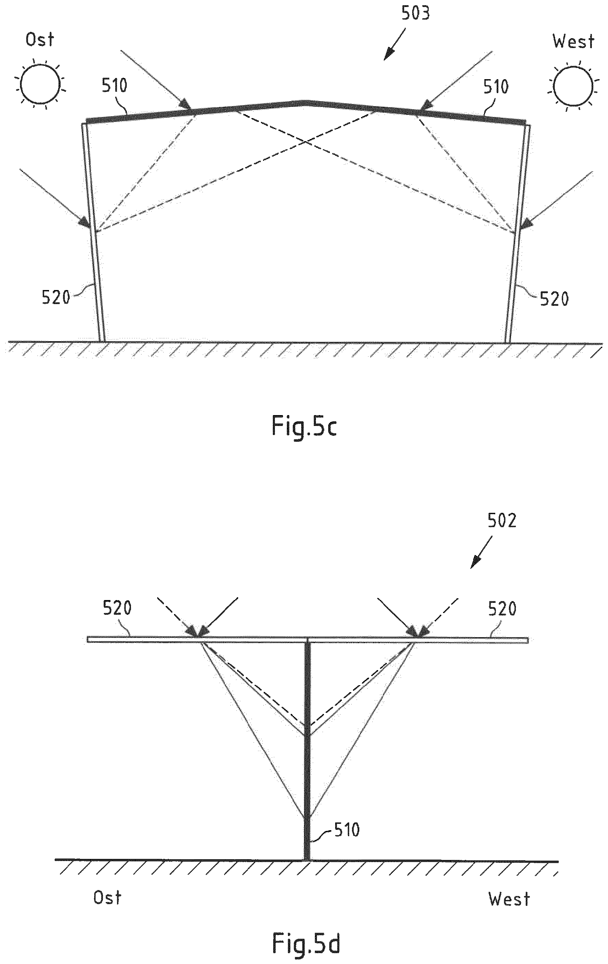

Die Anordnung 503 in Fig. 5c) ist ebenfalls auf einer Freifläche oder auf einem Flachdach in Ost-/West-Orientierung vorgesehen. Im Unterschied zu der Anordnung 501 aus Fig. 5a) umfasst die Anordnung hier im Querschnitt gesehen zwei gegeneinander abgewinkelte Solarmodule, an die sich an ihren Kanten jeweils eine im Wesentlichen vertikal verlaufende Lichtumlenkvorrichtung anschließt, womit effektiv eine Verdopplung der PV-Empfangsfläche für flache Umlenkwinkel ermöglicht wird. Die Lichtumlenkvorrichtungen sind dabei im Wesentlichen rechtwinkelig zu den Solarmodulen angeordnet, sodass diese im Ergebnis nicht streng vertikal, sondern nach innen gestellt. Alternativ ist jedoch denkbar, dass die Lichtumlenkvorrichtungen beispielsweise statt nach innen nach außen gestellt angeordnet sind.

Bei der Anordnung 504 in Fig. 5d) ist das Solarmodul 510 vertikal angeordnet. Es sind im Querschnitt gesehen zwei Lichtumlenkvorrichtungen 520 vorgesehen, welche in horizontaler Richtung verlaufen und sich an die obere Kante des Solarmoduls anschließen, sodass eine im Querschnitt gesehen T-förmige Anordnung entsteht. Sowohl die Vorderseite des Solarmoduls 510 als auch die Rückseite des Solarmoduls können dabei über eine jeweilige Lichtumlenkvorrichtung 520 bestrahlt werden.

Dabei kann die Lichtumlenkvorrichtung das Sonnenlicht winkelselektiv umlenken. Das durchgezogen gezeichnet einfallende Sonnenlicht wird aus einem zweiten Winkelbereich oder einer zweiten Raumhälfte wie zuvor beschrieben umgelenkt, während das gestrichelt gezeichnet einfallende Sonnenlicht aus einem ersten Winkelbereich oder einer ersten Raumhälfte im Wesentlichen ohne Umlenkung (oder jedenfalls unter geringerer Umlenkung als aus dem anderen Winkelbereich oder der anderen Raumhälfte) transmittiert wird.

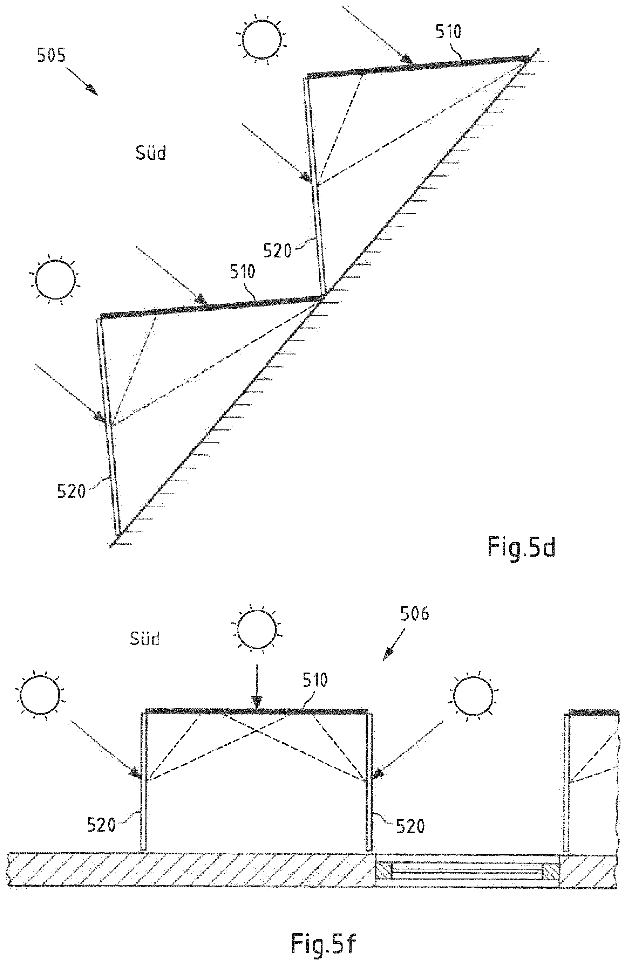

Fig. 5e) zeigt eine Anordnung 505 auf geneigtem Dach oder eine Freifläche (Böschung) in Südorientierung. Durch das Aneinanderreihen von mehreren Anordnungen aus Solarmodul und Lichtumlenkvorrichtung entlang des geneigten Grundes entsteht eine stufenförmige Anordnung aus abwechselnd vorgesehenen horizontal verlaufenden Solarmodulen und vertikal verlaufenden Lichtumlenkvorrichtungen. Die Anordnung ist besonders raumsparend, da keine gegenseitige Verschattung auftreten kann.

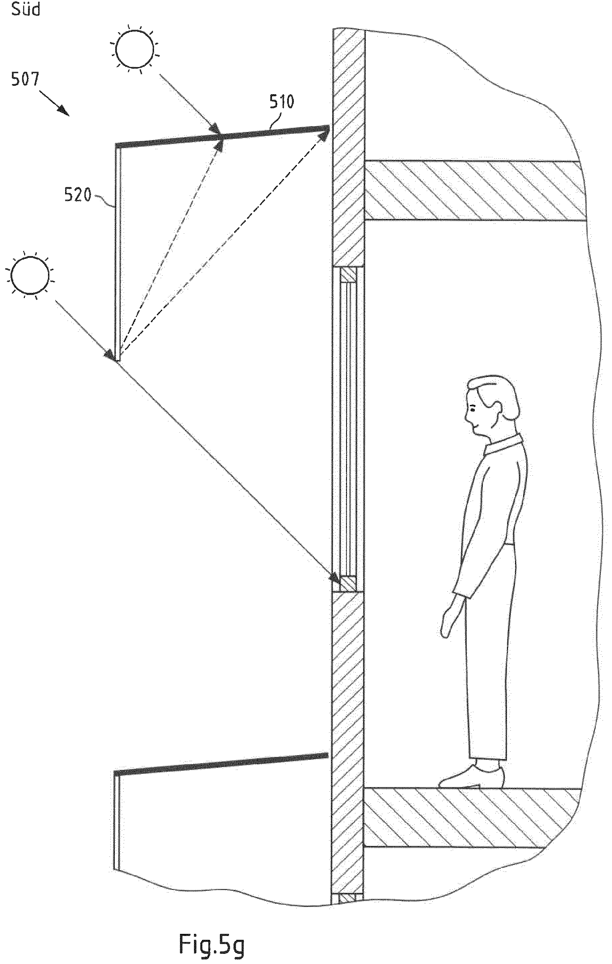

In den Fig. 5f) und 5g) ist jeweils ein Beispiel einer Anordnung 506, 507 als Fassadenintegration (Südorientierung) gezeigt, wobei in Fig. 5g) das Solarmodul eine zusätzliche Sonnenschutzfunktion ausüben kann.

In diesen Situationen ist die Lichtumlenkung besonders interessant, weil bifaziale Module hier normalerweise nur eine geringfügige Rückstrahlung erhalten. Wie im Horizontalschnitt in Fig. 5f) gezeigt, sind hier sowohl das Solarmodul 510 als auch die Lichtumlenkvorrichtungen 520 vertikal angeordnet, während wie in Fig. 5g) gezeigt eine geneigte horizontale Anordnung des Solarmoduls 510 oberhalb eines Fensters vorgesehen ist.

In der Ausgestaltung gemäß Fig. 5g) übernimmt die Anordnung aus Solarmodul 510 und Lichtumlenkvorrichtung 520 zudem auch die Funktion einer Fensterverschattung (Sonne-/Blendschutz). Die aufgezeigten Prinzipien lassen sich gut in Doppelfassaden mit vorgesetzter Glashaut und belüftetem Zwischenraum integrieren. Bei der in Fig. 5g) gezeigten Ausgestaltung kann für flache Umlenkwinkel zudem erreicht werden, dass das Sonnenlicht nicht auf das Solarmodul sondern durch das Fenster gelenkt wird, um die Tageslichtbeleuchtung zu verbessern. Mit andern Worten kann zusätzlich auch eine Verbesserung der Tageslichtbeleuchtung erreicht werden, indem das Sonnenlicht zumindest teilweise in das Fenster umgelenkt wird.

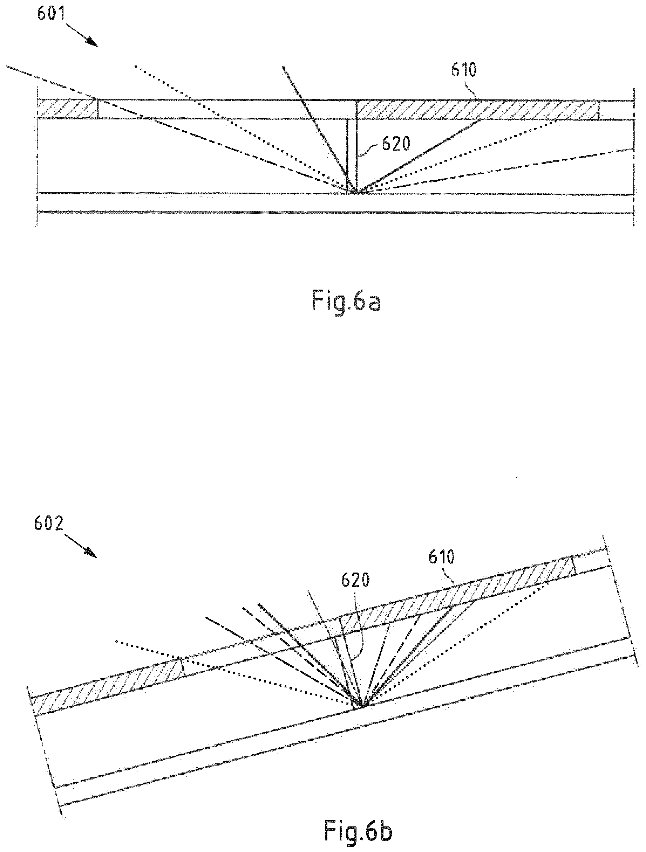

In den Fig. 6a)-d) sind nun verschiedene Ausführungsbeispiele von in Isolierglas integrierten Anordnungen 601-604 (beispielsweise von Glasdächern) gezeigt.

Die Anordnung 601 in Fig. 6a) zeigt ein Doppelisolierglas mit Südausrichtung, bei dem die Solarmodule 610 in die äußere Scheibe integriert sind oder auf diese aufgebracht sind. Die Lichtumlenkvorrichtungen 620 schließen sich jeweils einseitig senkrecht an die Solarmodule 610 bzw. die äußere Scheibe an. Das nächste Solarmodul ist beabstandet zu dem Solarmodul 610, sodass ausreichend Sonnenlicht auf die Lichtumlenkvorrichtung treffen kann. Das dargestellte Isolierglas kann auch Teil eines Glasdachs sein.

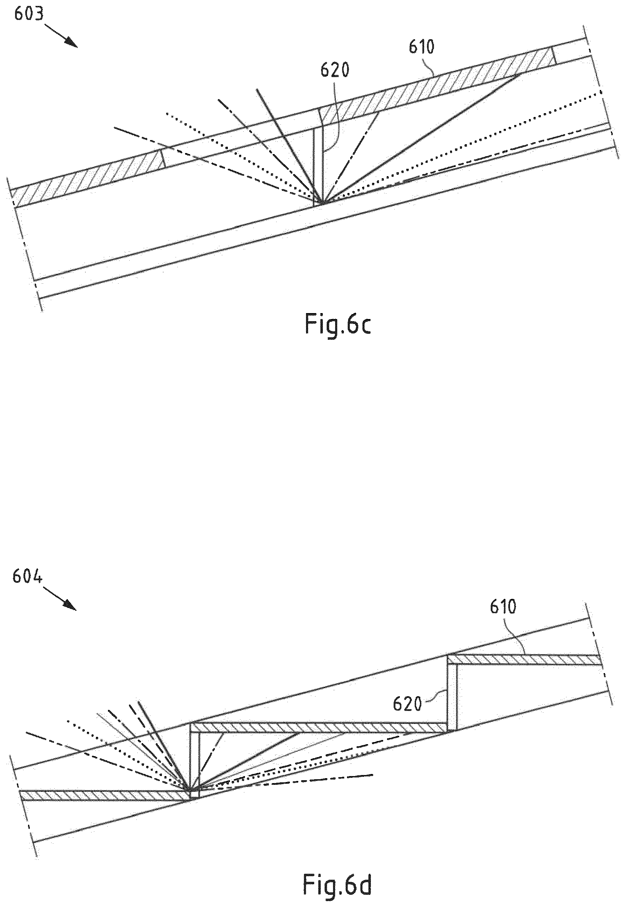

Wie mit der Anordnung 602 in Fig. 6b) dargestellt, können das Isolierglas und damit die Solarmodule 610 nicht horizontal verlaufen, sondern auch geneigt (hier mit einer Dachneigung von 15°). Dementsprechend sind die Lichtumlenkvorrichtungen 620 um 75° geneigt, sodass diese wiederum im Wesentlichen senkrecht zu den Solarmodulen 610 verlaufen. Unabhängig hiervon kann, wie in Fig. 6b angedeutet, die zwischen den einzelnen Solarmodulen befindliche Außenscheibe strukturiert (beispielsweise geriffelt) sein (was natürlich ebenso in den anderen Ausführungen der Fig. 6 möglich ist), um eine vertikale Streuung des Sonnenlichts zwischen den Isolierglasscheiben zu erzeugen.

In einer in Fig. 6c gezeigten alternativen Variante ist die Anordnung 603 bei geneigtem Isolierglas so vorgesehen, dass die Lichtumlenkvorrichtungen 620 ungeachtet des geneigten Isolierglases im Wesentlichen vertikal verlaufen, das heißt in diesem Fall ein Winkel von 105° zwischen Solarmodul 610 und Lichtumlenkvorrichtung 620 entsteht.

Die Ausgestaltung der Anordnung 604 in Fig. 6d) betrifft ebenfalls ein geneigtes Isolierglas. Dabei sind jedoch nicht nur die Lichtumlenkvorrichtungen 620, sondern auch die Solarmodule 610 im Zwischenraum des Isolierglases vorgesehen. In diesem Fall verlaufen die Solarmodule 610 horizontal, während die Lichtumlenkvorrichtungen 620 vertikal verlaufen die alternierende Anordnung von Solarmodul 610 und Lichtumlenkvorrichtung 620 ein stufenförmigen Aufbau im Inneren des Isolierglases ergibt. Gleichsam kann die Anordnung 604 jedoch auch beispielsweise eine einschalige Verschattungsvorrichtung sein.

In den Fig. 7a), b) soll nun ein Beispiel einer Mikrostruktur einer Lichtumlenkvorrichtung beschreiben werden.

So zeigen Fig. 7a), b) schematische Darstellungen einer Lichtumlenkvorrichtung mit viertellinsenförmiger Vorderseite (Lichteingangsseite) und stabprismenförmiger Rückseite (Lichtaustrittsseite). Die Strahlen 714 bis 717 entsprechen den Sonnenelevationswinkeln 15°, 30°, 45° und 60°. Die erfindungsgemäße Lichtumlenkvorrichtung ermöglicht die Umlenkung aller abgebildeten Strahlen. Das Strahlbündel 726 wird von der erfindungsgemäßen Lichtumlenkvorrichtung trotz verschiedener Strahlwege vollständig umgelenkt. Das Lichtbündel wird nach dem Eintritt in die Vorrichtung an den Punkten 727 und 728 fokussiert und im weiteren Verlauf winkelmäßig aufgeweitet.

Während bei rein prismatisch arbeitenden Verfahren einfallendes paralleles Licht im Wesentlichen in eine einzige - durch den Prismenwinkel definierte - Richtung abgelenkt wirkt und letztlich zur Bildung eines scharfen Schlagschattens sowie eines Farbsaumes führt, bewirken plankonvexe Linsenelemente auf der dem Lichteinfall zugewandten Seite zunächst eine Bündelung (727, 728) der einfallenden Strahlen und hinter dem Fokuspunkt eine anschließende winkelmäßige Aufweitung. Das so winkelmäßig aufgeweitete Licht wird auf der Lichtaustrittsseite durch prismatische Strukturen gezielt abgelenkt, wobei die erzielbaren Ablenkwinkel und zugehörigen Ablenkungswirkungsgrade durch die Prismengeometrie und die Geometrie der Gesamtanordnung (718 - 725) bestimmt werden. Durch die Winkelaufweitung des austretenden Lichtes wird zum einen der Schlagschatten aufgeweicht und zum anderen findet eine Farbmischung der beim Durchtritt durch die Prismen erzeugten Spektralfarben statt.

Als Profil der linsenförmigen Strukturen wird erfindungsgemäß ein 90°-Ausschnitt aus einer plankonvexen Linse gewählt, da dadurch zum einen die erwünschte Winkelaufweitung erreicht wird und zum anderen eine Planfläche für eine Strahlreflexion durch Totalreflexion zur Verfügung steht. Es ist dabei anzumerken, dass der Krümmungsradius der Linse für eine optimale Lichtumlenkwirkung größer ist als die Schenkellängen des 90°-Kreisausschnittes (vgl. Bezugszeichen 718 - 721).

Durch den Effekt der Winkelaufweitung und die zusätzliche Reflexionsebene an der Unterseite der Viertelkreislinsen wird eine deutliche Steigerung des Umlenkungswirkungsgrades insbesondere bei flacher Lichteinstrahlung erreicht. Das in Fig. 7a), b) gezeigte, beispielhafte Profil beruht auf den folgenden geometrischen Daten: Die Schenkellängen (718, 719) der linsenförmigen Struktur messen 100 µm, der Linsenradius (720) beträgt 141 µm. Der Mittelpunktswinkel des wölbungsbildenden Kreisbogens (721) beträgt 60°. Die prismatische Seite beruht auf folgenden Werten: horizontaler Schenkel der Prismenspitze (723) = 143 µm, Winkel der Prismenspitze (724) = 35°, Höhe der prismatischen Struktur (722) = 100 µm. Die Dicke der Lichtlenkvorrichtung (725) beträgt 1 mm. Diese Daten sind jedoch nur als ein mögliches nicht beschränkendes Ausführungsbeispiel zu verstehen.

Im Ergebnis wird eine effektive, breitbandige Lichtumlenkung des einfallenden Sonnenlichts für einen großen Einfallswinkelbereich durch Brechung bzw. Reflexion an den jeweiligen Grenzflächen erreicht.

Fig. 8 zeigt in weiteres Beispiel einer optimierten Mikrostruktur einer Lichtumlenkvorrichtung. Insbesondere kann mittels der in Fig. 8 gezeigten Ausgestaltung die in Fig. 7a), b) gezeigten linsenförmigen Strukturen optimiert werden.

So zeigt Fig. 8 ein Ausführungsbeispiel einer lichteintrittsseitigen Oberflächenstruktur mit zylinderlinsenförmigen Strukturelementen 8, wie sie beispielsweise anstelle der Oberflächenstruktur in der Lichtumlenkvorrichtung aus Fig. 7 verwendet werden kann. Die Strukturelemente 8 sind ein Beispiel für vergleichsweise große Strukturelemente (Gesamtbreite wₗ der Strukturelemente 8 etwa 891µm). Die Oberflächenstruktur bzw. eine entsprechende Lichtumlenkvorrichtung ist beispielsweise durch Heißprägen hergestellt. Vorzugsweise liegen dabei aber im Unterschied zu der Darstellung in Fig. 7 jedem zylinderlinsenförmigen Strukturelement 8 zwei stabprismenförmige Strukturelemente gegenüber.

Um eine verbesserte relative Transmission von Einfallswinkelns im Bereich von 70° bis 80° zu erzielen, kann das in Fig. 7 gezeigte Design der Strukturelemente der lichteintrittsseitigen Oberflächenstruktur durch das in Fig. 8 gezeigte Design ersetzt bzw. gemäß diesem abgewandelt werden.

Die zylinderlinsenförmigen Strukturelemente 8 weisen im Querschnitt gesehen jeweils einen Abschnitt 8.1 mit einem konvexen Linsenprofil 82 auf. Die zylinderlinsenförmigen Strukturelemente 8 weisen jeweils eine sich an den Abschnitt 81 mit dem konvexen Linsenprofil 82 anschließende Erhöhung 83 auf. Der Krümmungsradius r_{L} des konvexen Linsenprofils 82 beträgt in diesem Fall etwa 2595µm und ist damit größer als die Dimensionierung des Strukturelements 8 (etwa dessen Breite oder Höhe). Die Höhe hₗₛ des konvexen Linsenprofils 82 alleine beträgt etwa 530µm. Die Höhe der Erhöhung 83 (unter Vernachlässigung der Abrundung mit Radius rₗₛ) beträgt etwa 806µm. Die Erhöhung 83 wird aus einer sich an den Abschnitt 81 mit dem konvexen Linsenprofil 82 anschließenden steigenden Flanke 831 und einer sich an die steigende Flanke 831 anschließenden fallenden Flanke 832 gebildet.

In diesem Fall ist die steigende Flanke 831 der Erhöhung 83 ohne Krümmung ausgebildet. Die steigende Flanke 831 und die fallende Flanke 832 der Erhöhung 83 schließen in diesem Ausführungsbeispiel einen Winkel βₗₛ von etwa 35,4° ein. Die fallende Flanke 832 der Erhöhung 83 schließt mit der Normalen der Lichteintrittsseite 2 einen Winkel ϕₗ von etwa 0,3° ein, wobei es hier jedoch lediglich darauf ankommt, dass eine vergleichsweise steile Flanke gebildet wird. Der Übergang zwischen der steigenden Flanke 831 und der fallenden Flanke 832 ist mit einem Radius von etwa 43µm abgerundet. Die Breite des Abschnitts 81 mit dem konvexen Linsenprofil 82 ist mit etwa 691µm in diesem Fall deutlich größer ist als die Breite wₗₛ der Erhöhung 83 mit etwa 200µm. Wie in Fig. 8 gestrichelt angedeutet setzt sich das beschriebene Strukturelement 8 periodisch fort, um die Oberflächenstruktur zu bilden. Dabei gehen zwei benachbarte Strukturelemente mit einem geringen Radius rit (hiervon etwa 1,7µm) ineinander über.

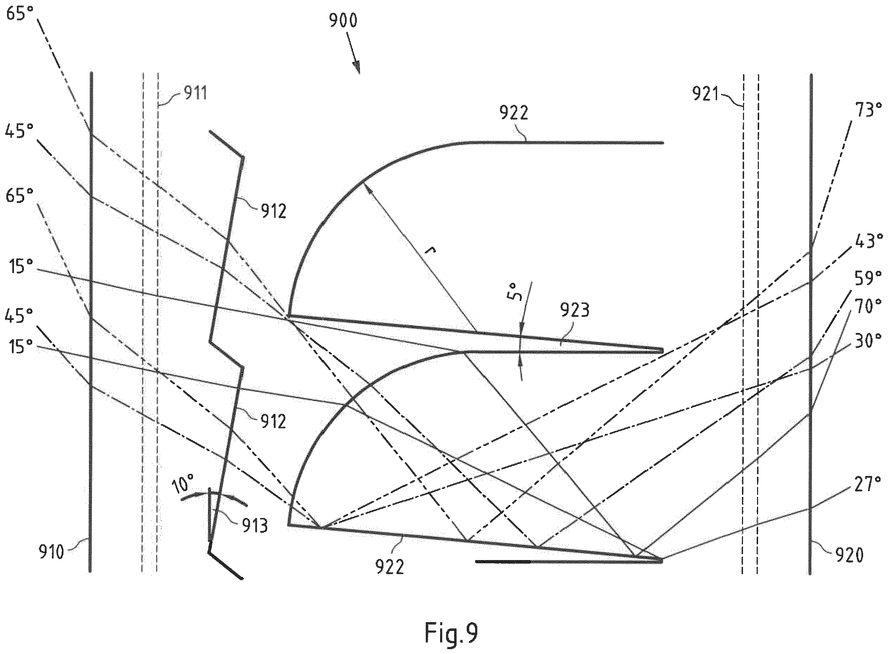

Fig. 9 zeigt in einer schematischen Ansicht im Längsschnitt ein weiteres Beispiel einer Mikrostruktur einer Lichtumlenkvorrichtung 900. Wie die vorherigen Lichtumlenkvorrichtungen, ist auch die Lichtumlenkvorrichtung 900 (insbesondere für die hier relevanten Wellenlängen des Sonnenlichts) transparent und weist eine dem Lichteinfall zugewandte Seite 910 (Lichteintrittsseite) und eine gegenüberliegende, dem Lichtaustritt zugewandte Seite 920 (Lichtaustrittsseite) auf. Im Gegensatz zu der in Fig. 7a, 7b gezeigten Lichtumlenkvorrichtung, weist die Lichtumlenkvorrichtung 900 die Mikrostruktur nicht auf den jeweiligen Außenseiten einer einzelnen oder einstückigen Scheibe auf, ist also nicht außenseitig beidseitig mikrostrukturiert, sondern besteht aus zwei Scheiben, welche auf der jeweiligen einander zugewandten Seite bzw. Innenseite mikrostrukturiert ist. Grundsätzlich wäre auch denkbar, dass beispielsweise lediglich einer der beiden Innenseiten mikrostrukturiert ist. Bei diesem Beispiel handelt es sich um PMMA-Scheiben, wobei jedoch auch andere Materialien denkbar sind. Dieser Aufbau hat den Vorteil, dass eine Funktionsbeeinträchtigung durch Verschmutzung, durch häufiges Reinigen oder durch physikalische Beschädigung der strukturierten Oberfläche mit nur einem zweischichtigen Aufbau weitestgehend vermieden werden kann. Bei den beidseitig und außenseitig strukturierten Scheiben kann zwar eine vergleichbarer Effekt durch eine Anordnung der mikrostrukturierten Lichtumlenkvorrichtung zwischen zwei Schutzscheiben oder -folien erfolgen kann, führt dies zu einem dreischichtigen Aufbau. Der zweischichtige Aufbau der Lichtumlenkvorrichtung 900 der Fig. 9 ist jedoch vorteilhaft, da dieser aufgrund des lediglich zweischichtigen Aufbaus reduzierte Transmissionsverluste aufweist. Hierzu könne die Scheiben beispielsweise mit einem Zwischenraum nach Art einer Isolierverglasung mit dichtem Randverbund zusammengebaut werden, wobei die Lichtumlenkung dann durch die Strukturierung der beiden Innenflächen zum Zwischenraum erfolgt.

Die beispielhaft in Fig. 9 dargestellte Lichtumlenkvorrichtung 900 mit Mikrostruktur weist auf der Innenseite der lichteintrittsseitigen Scheibe 911 eine innenseitige Mikrostruktur auf, welche in diesem Beispiel im Schnitt gesehen dreiecksförmige oder nahezu sägezahnartige Strukturelemente oder Erhebungen 912 (welche sich dann senkrecht zur Bildebene erstrecken und eine entsprechende prismenförmige Struktur bilden) aufweist. Wie in dem Beispiel dargestellt, können dies insbesondere unregelmäßige und/oder stumpfwinkelige Dreiecke sein. Ein Winkel 913 des Dreiecks liegt dabei vorzugsweise zwischen 5° und 20°, vorzugswiese beträgt dieser etwa 10°.

Auf der Innenseite der lichtaustrittsseitigen Scheibe 921 weist die Lichtumlenkvorrichtung 900 innenseitig eine Mikrostruktur auf, welche in diesem Beispiel im Schnitt gesehen abgerundete Strukturelemente oder Vorsprünge 922 (welche dann ebenfalls eine sich entsprechende senkrecht zur Bildebene erstreckende Struktur bilden) aufweist. Die Vorsprünge 922 erstrecken sich dabei in Richtung der Innenseite der lichteintrittsseitigen Scheibe 911. In diesem Beispiel sind einseitig abgerundete Vorsprünge 922 vorgesehen, welche im Schnitt gesehen im Wesentlichen eine Geometrie eines Viertelkreises beschreiben. Benachbarte Strukturelemente 922 schließen dabei im Wesentlichen unmittelbar aneinander an und bilden in diesem Beispiel einen Öffnungswinkel 923 zwischen benachbarten Strukturelementen 922 von ca. 1° bis 10°, vorzugsweise von etwa 5°.

In Fig. 9 sind weiterhin (vergleichbar mit Fig. 4) beispielhaft unterschiedliche Sonnen-Einfallswinkel von 15°, 45° und 65° jeweils an zwei unterschiedlichen Höhen auf die Lichtumlenkvorrichtung (linksseitig) und die hieraus resultierenden Strahlengänge und insbesondere die zugehörigen lichtaustrittsseitigen Umlenkwinkel (rechtsseitig) in Richtung des (nicht dargestellten) Solarmoduls (welches sich beispielsweise im Wesentlichen horizontal verlaufend, rechtsseitig oberhalb anschließen kann) eingezeichnet, welche zwischen 27° und 73° liegen. Wie zu erkennen ist, ermöglicht der in Fig. 9 gezeigte zweischeibige Aufbau der Lichtumlenkvorrichtung 900 mit der Mikrostrukturierung der beiden Innenflächen eine Umlenkung von einfallender Sonnenstrahlung aus einem großen Winkelbereich (15° bis 65°) in einen gewünschten Bereich.

### Referenzen:

[1] IEA Task 13, Performance, Operation and Reliability of Photovoltaic Systems - Bifacial PV Modules and Systems. Report IEA-PVPS T13-14:2021.
[2] Bifaziale Module -Herausforderungen, Vorteile und Aussichten, Jessica. blog.solartraders.com/2021/08/05/bifaziale-module
[3] Michael Jakubowsky: Optimierte Strukturen zur Tageslichtumlenkung von Jungbecker, 28.02.2019. Bericht im Rahmen des FuE-Vorhabens "TaLED"

## Patentansprüche

1. Anordnung umfassend
- ein bifaziales Solarmodul mit einer Vorderseite und einer Rückseite und
- eine mikrostrukturierte Lichtumlenkvorrichtung mit einer Mikrostruktur,
wobei die Anordnung derart ausgebildet ist, dass die mikrostrukturierte Lichtumlenkvorrichtung einfallendes Sonnenlicht mittels Brechung und/oder Reflexion zumindest teilweise und unmittelbar auf die Rückseite des bifazialen Solarmoduls umlenkt.

2. Anordnung nach Anspruch 1, wobei die Anordnung derart ausgebildet ist, dass die Vorderseite des bifazialen Solarmoduls unmittelbar von einfallendem Sonnenlicht beschienen wird.

3. Anordnung nach Anspruch 1 oder 2, wobei die Mikrostruktur der mikrostrukturierten Lichtumlenkvorrichtung derart ausgebildet ist, dass Sonnenlicht zumindest unter einem Einfallswinkel zur Senkrechten der Lichtumlenkvorrichtung von 40° bis 50°, vorzugsweise von 35° bis 55°, weiter vorzugsweise von 30° bis 60°, besonders bevorzugt von 15° bis 70° unmittelbar auf die Rückseite des bifazialen Solarmoduls umgelenkt wird.

4. Anordnung nach einem der vorhergehenden Ansprüche, wobei die Mikrostruktur der mikrostrukturierten Lichtumlenkvorrichtung derart ausgebildet ist, dass die relative Transmission im Bereich von Einfallswinkel von Sonnenlicht zur Senkrechten der Lichtumlenkvorrichtung von 40° bis 50°, vorzugsweise von 35° bis 55°, weiter vorzugsweise von 30° bis 60°, besonders bevorzugt von 15° bis 70°, zumindest 40%, vorzugsweise zumindest 50%, besonders bevorzugt zumindest 60% beträgt.

5. Anordnung nach einem der vorhergehenden Ansprüche, wobei die Mikrostruktur der mikrostrukturierten Lichtumlenkvorrichtung derart ausgebildet ist, dass für Einfallswinkel von Sonnenlicht zur Senkrechten der Lichtumlenkvorrichtung im Bereich von 45° der Umlenkwinkel zur Senkrechten der Lichtumlenkvorrichtung zumindest 40°, vorzugsweise zumindest 50, besonders bevorzugt zumindest 60° beträgt.

6. Anordnung nach einem der vorhergehenden Ansprüche, wobei die Mikrostruktur der mikrostrukturierten Lichtumlenkvorrichtung derart ausgebildet ist, dass für Einfallswinkel von Sonnenlicht zur Senkrechten der Lichtumlenkvorrichtung von 40° bis 50°, vorzugsweise von 35° bis 55°, weiter vorzugsweise von 30° bis 60°, besonders bevorzugt von 15° bis 70°, ein Großteil des umgelenkten Sonnenlichts in einen Winkelbereich von 10° bis 65°, besonders bevorzugt von 20° bis 40°, besonders bevorzugt 25° bis 35° umgelenkt wird.

7. Anordnung nach einem der vorhergehenden Ansprüche, wobei die Mikrostruktur der mikrostrukturierten Lichtumlenkvorrichtung derart ausgebildet ist, dass das einfallende Sonnenlicht winkelselektiv umgelenkt wird.

8. Anordnung nach einem der vorhergehenden Ansprüche, wobei die mikrostrukturierte Lichtumlenkvorrichtung und das bifaziale Solarmodul winkelig zueinander, insbesondere unter einem Winkel von zumindest 60°, vorzugsweise zumindest 75°, vorzugsweise im Wesentlichen rechtwinkelig, angeordnet sind.

9. Anordnung nach einem der vorhergehenden Ansprüche, wobei die mikrostrukturierte Lichtumlenkvorrichtung derart ausgebildet ist, dass diese einfallendes Sonnenlicht breitbandig, insbesondere zumindest teilweise im Bereich des sichtbaren Lichts und/oder zumindest teilweise im Bereich der Infrarotstrahlung, insbesondere im Bereich der nahe, mittleren und/oder fernen Infrarotstrahlung, umlenkt.

10. Anordnung nach einem der vorhergehenden Ansprüche, wobei im bestimmungsgemäß Gebrauch der Anordnung das Solarmodul im Querschnitt gesehen im Wesentlichen horizontal oder vertikal verläuft und/oder die Lichtumlenkvorrichtung im Querschnitt gesehen im Wesentlichen vertikal oder horizontal verläuft.

11. Anordnung nach einem der vorhergehenden Ansprüche, wobei die Anordnung weiterhin einen Montagegrund umfasst, wobei der Montagegrund eine Freifläche, ein Dach, insbesondere ein Flachdach, ein geneigtes Dach oder ein Glasdach, eine Fassade oder eine Glasscheibe, insbesondere eine Isolierglasscheibe, ist, und wobei das Solarmodul und/oder die mikrostrukturierte Lichtumlenkvorrichtung auf dem Montagegrund befestigt oder in diesen integriert ist.

12. Anordnung nach einem der vorhergehenden Ansprüche, wobei die strukturierte Lichtumlenkvorrichtung im Wesentlichen flächig ausgebildet ist und/oder aus Glas oder PMMA besteht.

13. Anordnung nach einem der vorhergehenden Ansprüche, wobei die Mikrostruktur der mikrostrukturierten Lichtumlenkvorrichtung auf der dem Lichteinfall zugewandten Seite eine zylinderlinsenförmige Oberflächenstruktur aufweist und/oder wobei die Mikrostruktur der mikrostrukturierten Lichtumlenkvorrichtung auf der dem Lichtaustritt zugewandten Seite eine stabprismenförmige Oberflächenstruktur besitzt.

14. Verwendung einer mikrostrukturierten Lichtumlenkvorrichtung mit einer Mikrostruktur zur zumindest teilweisen Umlenkung von einfallendem Sonnenlicht mittels Brechung und/oder Reflexion unmittelbar auf eine Rückseite eines bifazialen Solarmoduls.
